# EUROPEAN PATENT APPLICATION

(11) **EP 2 790 116 A1**
(43) Date of publication of application: **15.10.2014**
(21) Application number: 13162658.2
(22) Date of filing: 08.04.2013
(51) Int. Cl.: G06F 17/50

(54) **Development system for developing mechatronic systems, non-transitory data carrier, and method**

(71) Applicant: Siemens Aktiengesellschaft, 80333 München (DE)
(72) Inventor: Votintseva, Anjelika, 81735 München (DE)

(57) **Abstract**

The present invention provides a development system for developing mechatronic systems, comprising a memory configured to store generic component descriptions of mechatronic components of the mechatronic systems, at least one system interface coupled to said memory and configured to exchange the generic component descriptions with development tools of different development domains provided for developing the mechatronic systems, at least one adaptor coupled to said at least one system interface, wherein the stored generic component descriptions comprise generic descriptions of the input and/or output interfaces of the mechatronic components of the mechatronic system, and wherein said at least one adaptor is configured to translate the stored generic component descriptions into tool specific component descriptions of said development tools and/or translate the tool specific component descriptions of said development tools into generic component descriptions. The present invention, furthermore, provides a non-transitory data carrier and a method.

## Description

### TECHNICAL FIELD

The invention relates to development system for developing mechatronic systems, a non-transitory data carrier, and a corresponding method.

### BACKGROUND

Although applicable to any development system, the present invention will be described in combination with development systems for mechatronic systems.

In the development of mechatronic systems different development tools of different development domains, like the mechanical domain, the electric domain, the software domain and the like, are used to Complete the development of a mechatronic system.

In every development domain different interfaces are specified for the mechatronic components of a mechatronic system. For example, in the mechanical domain the mechanical interfaces like connectors, sockets and the like, in the electrical domain the characteristics of the electrical interfaces like maximum current and voltage of an interface can be defined, and in the software domain the logical description of the data transmitted over said interfaces, like a bus-protocol or high/low active can be defined.

During the development of a mechatronic system different interfaces are specified in the different development tools of the different development domains. It is important to interchange information about said interfaces between one development domain and the other development domain to keep the definitions of the interfaces consistent throughout the different development domains.

Furthermore, in every development domain there can be information about different details of a mechatronic component in the specific development domain. The details can include timing details, safety details, static details, dynamic details and the like.

Usually every development tool uses a proprietary data format to store the domain specific information about the different mechatronic components. Even development tools of the same development domain usually use different proprietary data formats if the development tools are provided by different tool vendors. Therefore, the exchange of information between the different development tools of the different development domains is very difficult, if not impossible.

Furthermore, today no method exists to compose a mechatronic system by combining the information of the different development domains and the different aspects of the different development domains.

Therefore, there is a need for a method and an apparatus for providing a better integration of available information during the development of a mechatronic system.

### SUMMARY

This problem is solved by the features of the independent claims.

Accordingly, the present patent application provides:
- A development system for developing mechatronic systems, comprising a memory configured to store generic component descriptions of mechatronic components of the mechatronic systems, at least one system interface coupled to said memory and configured to exchange the generic component descriptions with development tools of different development domains provided for developing the mechatronic systems, at least one adaptor coupled to said at least one system interface, wherein the stored generic component descriptions comprise generic descriptions of the input and/or output interfaces of the mechatronic components of the mechatronic system, and wherein said at least one adaptor is configured to translate the stored generic component descriptions into tool specific component descriptions of said development tools and/or translate the tool specific component descriptions of said development tools into generic component descriptions.
- A non-transitory data carrier, especially for use in a development system according to the present invention, comprising a data structure, the data structure comprising generic component descriptions of mechatronic components of the mechatronic systems, wherein the generic component descriptions comprise at least a name of the corresponding mechatronic components and/or a list of input interfaces of the corresponding mechatronic components and/or a list of output interfaces of the corresponding mechatronic components, and wherein the description of the input interfaces and/or the output interfaces of the corresponding mechatronic components comprises at least a name and/or one of the types input or output and/or a multiplicity and/or a category and/or at least one aspect and/or at least one proprietary extension, and/or wherein every aspect in a description of one of the input and/or output interfaces comprises a specification about the respective input and/or output interface for one specific development domain, and/or wherein every proprietary extension of one of the input and/or output interfaces comprises an information which is provided in a proprietary format of at least one of the development tools.
- A method for developing mechatronic systems, comprising the steps storing generic component descriptions of mechatronic components of the mechatronic systems, wherein the stored generic component descriptions comprise generic descriptions of the input and/or output interfaces of the mechatronic components of the mechatronic system, translating the stored generic component descriptions into tool specific component descriptions of development tools provided for developing the mechatronic systems, send the translated generic component descriptions to development tools of different development domains, receive tool specific component descriptions from said development tools, and translate the tool specific component descriptions of said development tools into generic component descriptions.

The present invention is based on the conclusion that the development of mechatronic systems could be improved or rather the efficiency of the development process could be improved if a consistent base of information was used for the different development tools of the different development domains.

Therefore, the present invention uses this knowledge to provide generic component descriptions which comprise descriptions of the input and output interfaces of the different mechatronic components which can be used in the development of mechatronic systems. To provide a central database for the generic component descriptions the present invention provides a memory in the development system which stores the generic component descriptions.

Furthermore, in order to provide compatibility with different development tools of different development domains, which can all store their data in proprietary data formats, the present invention provides adaptors, which are configured to translate the generic component descriptions into tool specific component descriptions or vice-versa.

By providing the adaptors the present invention allows different development tools to work on the same data basis and exchange information via the generic component descriptions.

The development system according to the present invention assumes that different development tools of different development domains provide tool specific specifications of mechatronic components, such as models, codes or other kind of information. As each tool can only process data from some of the different aspects, the generic component descriptions serve as a collection of data for a single mechatronic component.

A development tool can for example request information about a specific mechatronic component or about a composite mechatronic component, which comprises several sub components of the development system.

The development tool or the adaptors can than filter the data which is stored in the generic component descriptions which is needed by the respective development tool.

Because the adaptors are also capable of translating the tool specific component descriptions into generic component descriptions the tools can also write back modified component descriptions to the generic component descriptions.

Consequently, the present invention allows combining specifications of mechatronic components of different development domains into a universal specification. Furthermore, the universal specification can be automatically projected into specific tools or languages via the adaptors.

Further embodiments of the present invention are subject of the further subclaims and of the following description, referring to the drawings.

In a possible embodiment the generic component descriptions comprise at least a name of the corresponding mechatronic components and/or a list of input interfaces of the corresponding mechatronic components and/or a list of output interfaces of the corresponding mechatronic components. This allows easily identifying the corresponding mechatronic components in the generic component description.

In a possible embodiment the description of the input interfaces and/or the output interfaces of the corresponding mechatronic components comprises at least a name and/or one of the types input or output and/or a multiplicity and/or a category and/or at least one aspect and/or at least one proprietary extension. This information allows customising the content of the generic component descriptions to match different types of mechatronic components.

In a possible embodiment every aspect in a description of one of the input and/or output interfaces comprises a specification about the respective input and/or output interface for one specific development domain. This allows concentrating the information from different development domains in one single generic component description for one single mechatronic component.

In a possible embodiment every proprietary extension of one of the input and/or output interfaces comprises information data which is provided in a proprietary format of at least one of the development tools. This allows providing tool specific information together with the generalized information that is stored in the generic component descriptions.

In a possible embodiment the generic component descriptions are provided in a human readable format, especially in an XML format. This allows a human being to read the generic component descriptions without a special tool and, furthermore, allows to handle the generic component descriptions with well-known and standardized tools and libraries.

In a possible embodiment the at least one adaptor is configured to translate the generic component descriptions into a component description according to a standardized description format. If the generic component descriptions are translated into a standardized description format instead of a tool specific format the component descriptions will be readable by a plurality of different tools with only one translation.

In a possible embodiment the development system comprises a first determination unit coupled to the memory and configured to determine whether a first input and/or output interface satisfies a second input and/or output interface and/or whether the first input and/or output interface can be connected to the second input and/or output interface and/or whether the first input and/or output interface can be used instead of the second input and/or output interface. This allows an automatic determination of whether one interface is in some way compatible with a second interface.

In a possible embodiment the development system comprises a second determination unit coupled to the memory and configured to determine whether a first mechatronic component is compatible with a second mechatronic component and/or whether the first mechatronic component can be connected to the second mechatronic component and/or whether the first mechatronic component can be used instead of the second mechatronic component. This allows an automatic determination of whether one mechatronic component is in any way compatible with a second mechatronic component.

In a possible embodiment the development system comprises a first searching unit coupled to the memory and configured to search all compatible mechatronic components for a selected mechatronic component. In one embodiment the first searching unit is configured to use the first and second determination units to find a compatible mechatronic component.

In a possible embodiment the development system comprises a second searching unit coupled to the memory and configured to search all compatible input and/or output interfaces for a selected input and/or output interface. In one embodiment the second searching unit is configured to use the first and second determination units to find a compatible mechatronic component.

Providing searching units allows to aid the development process by providing a possibility to identify compatible interfaces and mechatronic components very fast.

In a possible embodiment the development system comprises a configuration interface adapted to receive generic component descriptions for at least one mechatronic component. In one embodiment the configuration interface is a graphical user interface.

In a possible embodiment the development system comprises a user interface configured to provide editing means to a user for editing the generic component descriptions. In one embodiment the user interface is a web based user interface. This allows easy editing of the generic component descriptions.

In a possible embodiment the development system comprises a suggestion processor configured to suggest input interfaces corresponding to at least one output interface of a selected mechatronic component and/or to suggest output interfaces corresponding to input interfaces of the selected mechatronic component. This allows supporting a user in creating new generic component descriptions by taking from him the effort of finding compatible input and/or output interfaces for his newly created or modified generic component descriptions.

In a possible embodiment the suggestion processor is configured to output suggested input interfaces and/or suggested output interfaces via the user interface.

In a possible embodiment the user interface comprises first input means configured to receive new input and/or output interfaces for the respective mechatronic component which generic component description is currently edited by the user.

In a possible embodiment the user interface comprises second input means configured to receive a new specification for an interface of the mechatronic component which generic component description is currently edited by the user.

Providing the user with first and second input means allows the user to efficiently create or modify generic component descriptions.

In a possible embodiment the user interface comprises a search mask configured to receive a search term for searching generic component descriptions at least by component names and/or interface names.

### BRIEF DESCRIPTION OF THE DRAWINGS

For a more Complete understanding of the present invention and advantages thereof, reference is now made to the following description taken in conjunction with the accompanying drawings. The invention is explained in more detail below using exemplary embodiments which are specified in the schematic figures of the drawings, in which:
- Fig. 1: shows a block diagram of an embodiment of a development system according to the present invention;
- Fig. 2: shows a block diagram of an embodiment of a data carrier according to the present invention;
- Fig. 3: shows a flow diagram of an embodiment of a method according to the present invention;
- Fig. 4: shows a block diagram of a mechatronic system developed with a development system according to the present invention;
- Fig. 5: shows an embodiment of a user interface according to the present invention;
- Fig. 6: shows a combination of two mechatronic components into a subsystem; and
- Fig. 7: shows a connection between two interfaces;
- Fig. 8: shows a block diagram of an embodiment of a development system according to the present invention;
- Fig. 9: shows a flow diagram of an embodiment of a method according to the present invention.

The accompanying drawings are included to provide a further understanding of the present invention and are incorporated in and constitute a part of this specification. The drawings illustrate the embodiments of the present invention and together with the description serve to explain the principles of the invention. Other embodiments of the present invention and many of the intended advantages of the present invention will be readily appreciated as they become better understood by reference to the following detailed description. The elements of the drawings are not necessarily drawn to scale relative to each other. Like reference numerals designate corresponding similar parts.

### DETAILED DESCRIPTION OF THE DRAWINGS

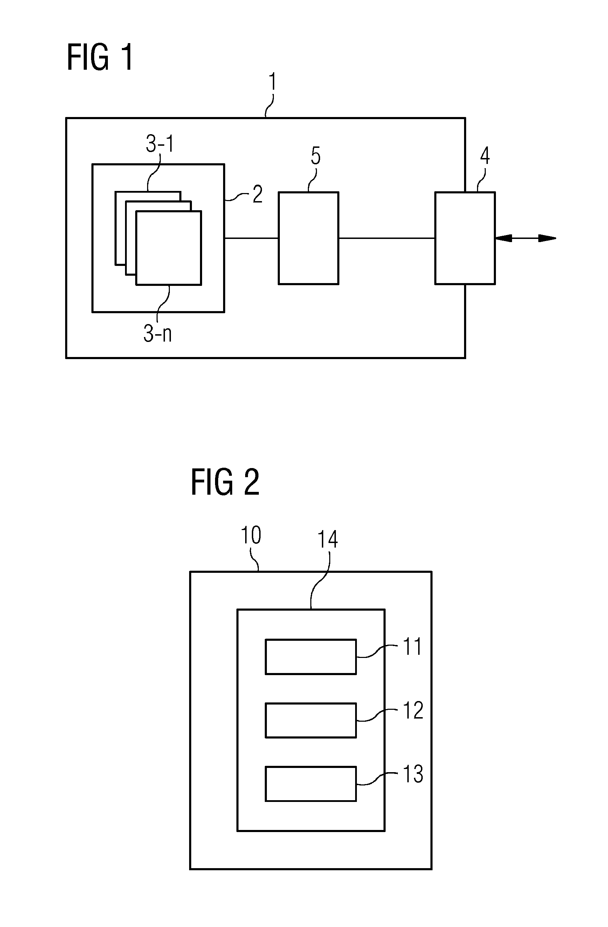

Fig. 1 shows a block diagram of an embodiment of a development system according to the present invention.

The development system 1 in Fig. 1 comprises a memory 2 which is coupled to an adaptor 5. The adaptor 5 is coupled to a system interface 4, wherein the system interface 4 is configured to exchange the generic component descriptions 3-1 - 3-n with development tools of different development domains.

The memory 2 is configured to store the generic component descriptions 3-1 - 3-n of the mechatronic components Comp1, Comp2 which can be used to develop mechatronic systems 20. The stored generic component descriptions 3-1 - 3-n comprise generic descriptions of the input and/or output interfaces IntI1, IntI'2, IntI'3, IntO1, IntO2, IntO'3, IntO'4 of the mechatronic components Comp1,Comp2 of the mechatronic system 20. The adaptor 5 is configured to translate the stored generic component descriptions 3-1 - 3-n into tool specific component descriptions of said development tools and/or translate the tool specific component descriptions of said development tools into generic component descriptions 3-1 - 3-n.

In one embodiment the development system 1 of Fig. 1 is a server computer, which includes at least one hard disk as memory 2 and the system interface 4 is a network interface, e.g. an Ethernet interface 4. Finally, the adaptor 5 can be embodied as software module 5.

In a possible embodiment the generic component descriptions comprise at least a name of the corresponding mechatronic components and/or a list of input interfaces of the corresponding mechatronic components and/or a list of output interfaces of the corresponding mechatronic components.

In a possible embodiment the description of the input interfaces and/or the output interfaces of the corresponding mechatronic components comprises at least a name and/or one of the types input or output and/or a multiplicity and/or a category and/or at least one aspect and/or at least one proprietary extension.

In a possible embodiment every aspect in a description of one of the input and/or output interfaces comprises a specification about the respective input and/or output interface for one specific development domain.

In a possible embodiment every proprietary extension of one of the input and/or output interfaces comprises information data which is provided in a proprietary format of at least one of the development tools.

In a possible embodiment the generic component descriptions are provided in a human readable format, especially in an XML format.

In one embodiment an exemplary generic component description for a mechatronic component "Comp1" looks like the following XML-Code:

```
 <XML::ComponentInterfaces componentName="Comp1" DBid="idX"...
    (otherProperties) >
    <Interface name="IntO1" DBid="idY" InOrOut="Provided"
        multiplicity="1" category="Testing"...
        (otherProperties) >
        <Aspect name="Software"... (otherProperties) >
          <Specification name="Element1" DBid="id1"
              multiplicity="*"... (otherProperties) >
            <Category mainName=ToolSet1" otherTags="real-time
                safety"\>
            <Value minValue="val1" maxValue="val2"
                initialValue="val3"\>
            <Type name="integer" subtypes="dblD1 dblD2 ..."
                supertypes="dblD3 dblD4 ..."\>
            <Unit name="degree"\> ... (otherProperties)
            <ProprietaryExtension format="TTCN">
              <Body text="a text in the proprietary format"
                \>
            <\ProprietaryExtension>
          <\Specification>
          <Specification Name="Element2" DBid="id12"
              multiplicity="*"... (otherProperties) >
            <Category mainName="SW" otherTags="functional"\>
            <Value minValue="val2"\>
            <Type name="bool"\>
            <Unit name=""\>
            (otherProperties)
            <ProprietaryExtension format="XMI-Rhapsody">
              <Body text="a text in the proprietary format"
                \>
            <\ProprietaryExtension>
          <\Specification>
          <Specification Name="Trace1" DBid="id30"
              multiplicity="*"... (otherProperties)>
            <Category mainName="Behavior" otherTags="array
                software"\>
            <Value minValue=""\>
            <Type name="char" subtypes="Pairs"
                supertypes="char*"\>
            <Unit name=""\> ... (otherProperties)
            <ProprietaryExtension format="List">
              <Body text="(0;1) (1;1) (2;5) (3;10)..." \>
            <\ProprietaryExtension>
         <\Specification>
         <ProprietaryExtension format="FormatName">
            <Body text="a text in the proprietary format" \>
         <\ProprietaryExtension>
       <\Aspect>
        <Aspect name="Mechanical" ... (otherProperties) >
          <Specification name="Plug" DBid="11"
              multiplicity="1"... (otherProperties) >
            <Category mainName="allPhysic"
                otherTags="electrical"\>
            <Value initialValue="USB2"\>
            <Type name=""\>
            <Unit name=""\> ... (otherProperties)
            <ProprietaryExtension format="NX">
              <Body text="a text in the proprietary format"
                \>
            <\ProprietaryExtension>
          <\Specification>
        <\Aspect>
        <Aspect name="Simulation"... (otherProperties) >
          <Specification Name="Element3" DBid="id13"
              multiplicity="number1"... (otherProperties) >
            <Category mainName="FMI">
            <Value initialValue="val3"\> ...
                (otherProperties)
          <\Specification> ... (otherProperties)
       <\Aspect>
   <\Interface>
   <\XML::ComponentInterfaces>
```

In the XML code the start tag
<XML::ComponentInterfaces componentName="Comp1"
indicates that the following XML code provides information about the input and output interfaces of the mechatronic component "Comp1". Following the component definition follows one exemplary interface definition:

```
    <Interface name="IntO1" DBid="idY" InOrOut="Provided"
        multiplicity="1" category="Testing"...
        (otherProperties)>
```

The interface definition defines the name of the interface "IntO1" and the direction of the interface ("InOrOut"). The term "provided" means that the mechatronic component provides an interface, therefore the interface is of direction "out". The multiplicity refers to the number of remote interfaces of other mechatronic components that can be coupled to the interface.

Under the interface definition follow a number of aspect definitions of the type:

```
    <Aspect name="Software"... (otherProperties) >
        ...
    <\Aspect>
    <Aspect name="Mechanical" ... (otherProperties) >
        ...
    <\Aspect>
    <Aspect name="Simulation"... (otherProperties) >
        ...
    <\Aspect>
```

This XML snippet shows clearly how the different development domains can be included into the interface definition by defining one aspect for every domain.

Under the single aspects XML-specifications of the type <Specification> ... </Specification> describe the single elements of the specific interface. Possible XML elements are:

```
    <Category mainName=" " otherTags=" "\>
    <Value initialValue=" "\>
    <Type name=""\>
    <Unit name=""\>
    <ProprietaryExtension format="XXX">
          <Body text="a text in the proprietary format" \>
    <\ProprietaryExtension>
```

The XML part within the Tags <ProprietaryExtension format="XXX"> ... <\ProprietaryExtension> is used to keep information in the generic component description which is needed by specific development tools, programming languages or development technologies. This information will not be parsed by the adaptor 5 but will directly be transmitted to the respective development tool, which will then parse the information. This information can be used by the tools e.g. for performing analysis, testing, simulations, or the like. Other tools simply ignore this information. This XML-element allows more flexibility in adaptor development because when tools evolve the additional information can simply be stored as proprietary extension of a generic component description. If for example the definition of the generic component description evolves, the proprietary extensions can be translated into newly created standard elements of the generic component description.

In other embodiments other XML elements are also possible. This is indicated in the above example by "(otherProperties)".

When defining interfaces in XML the interfaces and their elements may be categorized. This can be done by including the "category=" element in the respective definition. This helps reduce search efforts when trying to identify compatible candidates and can also be used for consistency checks. For example, if the interface has the category "Software" and is a provided interface (out interface), then its multiplicity within any component (as well as the multiplicity of all its elements) can be "*", meaning it can be connected to an unlimited number of required SW interfaces (any required interface in embodiment my use provided SW interfaces).

The above XML example is just exemplary and in other embodiments the XML-tags which are used to structure the generic component description differ from the XML-tags shown in this example.

Fig. 2 shows a block diagram of an embodiment of a data carrier 10 according to the present invention.

The data carrier 10 comprises a data structure 14. The data structure 14 represents a mechatronic component Comp1, Comp2. For the mechatronic component Comp1, Comp2 the data structure 14 stores at least a name 11, a list of input interfaces 12 and a list of output interfaces 13.

The data carrier 10 in Fig. 2 comprises only one data structure 14. In another embodiment the data carrier 10 comprises a plurality of data structures 14 for a plurality of respective mechatronic components Comp1, Comp2.

The data structure 14 can be embodied as an XML-structure according to the description regarding Fig. 1. In another embodiment the data structure 14 is embodied in any other computer readable format.

In another embodiment the data carrier 10 comprises a computer program, which when executed causes a processor to:
translate generic component descriptions 3-1 - 3-n into tool specific component descriptions of development tools provided for developing mechatronic systems 20, and send the translated generic component descriptions 3-1 - 3-n to development tools of different development domains; and/or
receive tool specific component descriptions from said development tools, and translate the tool specific component descriptions of said development tools into generic component descriptions 3-1 - 3-n; and/or
determine whether a first input and/or output interface IntI1, IntI'2, IntI'3, IntO1, IntO2, IntO'3, IntO'4 satisfies a selected second input and/or output interface IntI1, IntI'2, IntI'3, IntO1, IntO2, IntO'3, IntO'4 and/or whether the first input and/or output interface IntI1, IntI'2, IntI'3, IntO1, IntO2, IntO'3, IntO'4 can be connected to said selected second input and/or output interface IntI1, IntI'2, IntI'3, IntO1, IntO2, IntO'3, IntO'4 and/or whether the first input and/or output interface IntI1, IntI'2, IntI'3, IntO1, IntO2, IntO'3, IntO'4 can be used instead of said selected second input and/or output interface IntI1, IntI'2, IntI'3, IntO1, IntO2, IntO'3, IntO'4; and/or
determine whether a first mechatronic component Comp1, Comp2 is compatible with a second mechatronic component Comp1,Comp2 and/or whether the first mechatronic component Comp1, Comp2 can be connected to the second mechatronic component Comp1, Comp2 and/or whether the first mechatronic component Comp1, Comp2 can be used instead of the second mechatronic component by comparing the input and/or output interfaces IntI1, IntI'2, IntI'3, IntO1, IntO2, IntO'3, IntO'4 of said first and second mechatronic components Comp1, Comp2; and/or
search all compatible mechatronic components Comp1, Comp2 for a selected mechatronic component Comp1, Comp2; and/or
search all compatible input and/or output interfaces IntI1, IntI'2, IntI'3, IntO1, IntO2, IntO'3, IntO'4 for a selected input and/or output interface IntI1, IntI'2, IntI'3, IntO1, IntO2, IntO'3, IntO'4

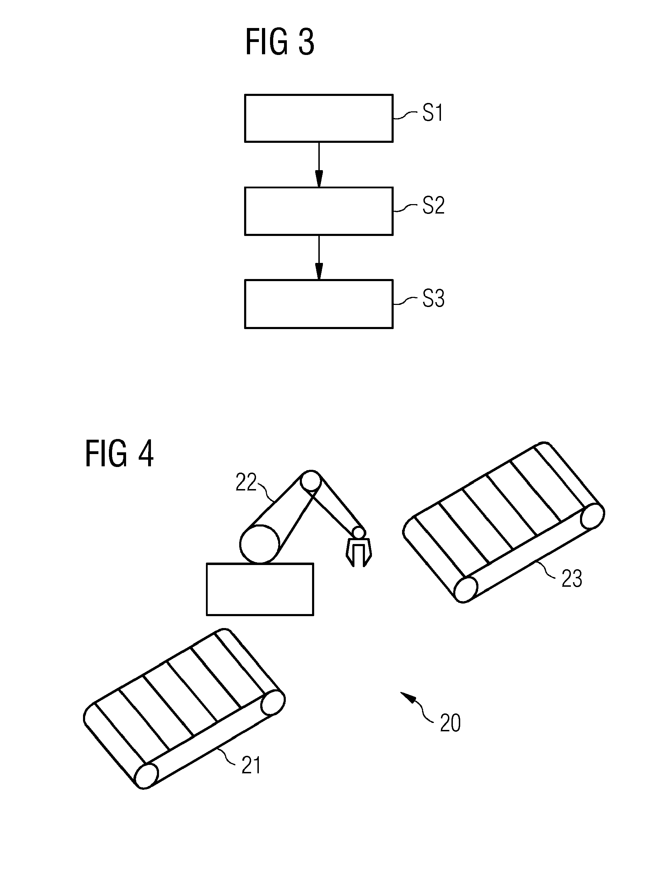

Fig. 3 shows a flow diagram of an embodiment of a method according to the present invention.

In a first step S1 generic component descriptions 3-1 - 3-n of mechatronic components Comp1, Comp2 of the mechatronic systems 20 are stored, wherein the stored generic component descriptions 3-1 - 3-n comprise generic descriptions of the input and/or output interfaces IntI1, IntI'2, IntI'3, IntO1, IntO2, IntO'3, IntO'4 of the mechatronic components Comp1, Comp2 of the mechatronic system 20.

A second step S2 comprises translating the stored generic component descriptions 3-1 - 3-n into tool specific component descriptions of development tools provided for developing the mechatronic systems 20, and sending the translated generic component descriptions 3-1 - 3-n to development tools of different development domains.

In a third step S3 tool specific component descriptions are received from said development tools, and the tool specific component descriptions of said development tools are translated into generic component descriptions 3-1 - 3-n.

Fig. 4 shows a block diagram of a mechatronic system 20 developed with a development system according to the present invention.

The mechatronic system 20 comprises a first conveyor 21 and a second conveyor 23. Between the first conveyor and the second conveyor a grappler 22 is installed to move goods from conveyor 21 to conveyor 23.

In today's development systems for mechatronic systems a top-down approach is used. This means that first the mechanical aspects, like dimensions of the mechatronic components of the mechatronic system are defined and then the other development domains can work on this data.

Using the present invention a much more flexible development becomes possible and it is possible to reflect changes of mechatronic components that occur in other domains than the mechanical domain back to the mechanical domain.

With regard to the mechatronic system 20 of Fig. 4 in a first step a developer of the mechanical domain can define the dimensions of the mechatronic components 21, 22 and 23. For example the developer would define the width and the length and e.g. the maximum transportable weight of the first conveyor 21 and the second conveyor 23. Furthermore, the developer would define the reach and movement angels of the grappler 22.

In the electrical domain a developer would then define all electrical values like the input voltages and currents, the types of interfaces of the different mechatronic components 21, 22 and 23. The types of interfaces could for example be bus types, high/low active discrete digital signals and the like.

Finally, a programmer would develop a control program based on the information that is provided by the mechanical and the electrical domain.

According to the present invention all this information would be stored in a generic component description 3-1 - 3-n of a development system 1.

The development system 1 would then always provide the latest information to the different developers or development tools, respectively.

If for example the programmer decided that another bus type should be used for a control interface, the programmer would simply change the bus type in the software development tool. This could for example be necessary because a certain bus type is much easier to work with in the software domain, e.g. because the bus protocol is less Complex.

The development system 1 would receive this updated information about the bus type from the software development tool and store this information in the respective generic component description 3-1 - 3-n of the respective mechatronic component 21, 22, 23.

Furthermore, the development system 1 would use its adaptors to translate this information for the other development domains.

Accordingly, in the electrical development domain the developer would see the updated bus type. This allows the developer to check if the remaining elements of the respective mechatronic component 21, 22, 23 are compatible with the new bus type. If necessary the developer could change incompatible part like e.g. power supplies, electric motors or transceiver elements.

In the mechanical domain the developer could - exactly as the developer of the electrical domain - check all the mechanical elements for compatibility. For example the developer could check the connectors and sockets for compatibility with the new bus type.

The above example combines the three development domains mechanical, electrical and software. But in other embodiments, different development domains can be included.

In one example, for example in the simulation domain it can be determined that a casing of a mechatronic component 21, 22, 23 has to be more robust and therefore has to be changed. This could lead to a heavier mechatronic component 21, 22, 23 and this could make more powerful electric motors necessary.

All this changes which are based on the simple conclusion of the simulation could be reflected by one single generic component description 3-1 - 3-n and then could be automatically translated to the tool specific component descriptions of the different development domains with the help of the present invention.

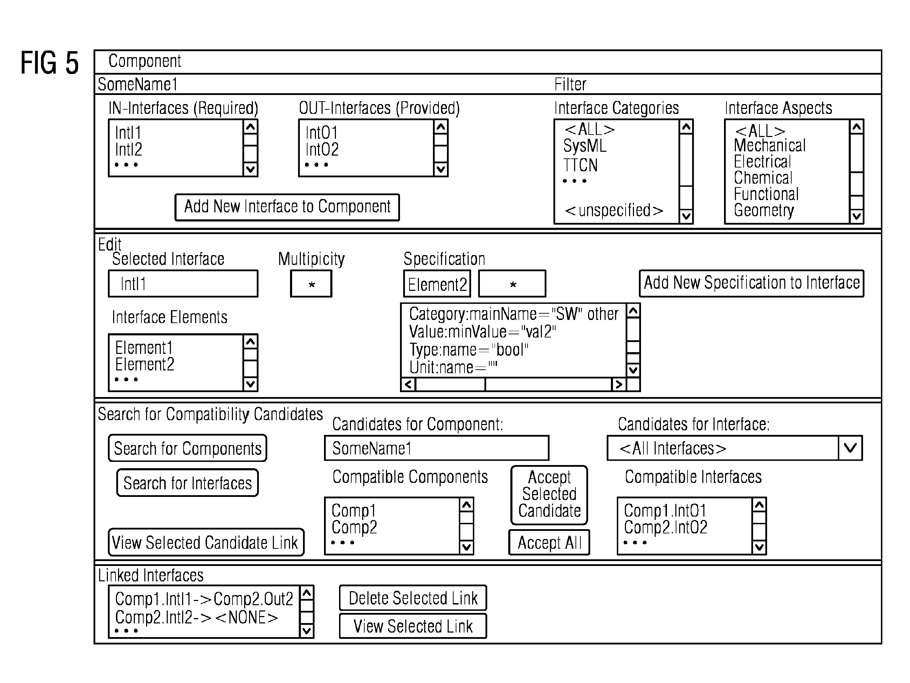

Fig. 5 shows an embodiment of a user interface according to the present invention.

The user interface of the present invention shows a generic tool independent user interface for specifying generic component descriptions 3-1 - 3-n according to the present invention.

The user interface provides an input field for the component name of the mechatronic component Comp1, Comp2 that a user wants to edit. Furthermore the user interface provides filters to filter the displayed information for interface categories and interface aspects.

Two lists are presented to the user, wherein one list shows available IN-Interfaces and the other shows available OUTInterfaces. Together with the two lists the user interface shows a button which leads to a sub user interface which can be used to add new interfaces to the mechatronic component Comp1, Comp2.

In a second section of the user interface the user interface displays editing means for editing input and output interfaces IntI1, IntI'2, IntI'3, IntO1, IntO2, IntO'3, IntO'4.

A first selection field allows a user to select the respective input or output interface IntI1, IntI'2, IntI'3, IntO1, IntO2, IntO'3, IntO'4. Further input fields are provided to select Elements of the selected interface, the multiplicity and a specification of the selected interface. Furthermore, the user interface comprises a button which leads to a sub user interface which can be used to add new specifications to respective interface.

In a third section the user interface provides user inputs to search for compatible candidates of mechatronic components Comp1, Comp2 or interfaces of mechatronic components Comp1, Comp2.

In this section the user interface provides suggestions for compatible mechatronic components Comp1, Comp2 or compatible interfaces if a user selects a mechatronic component Comp1, Comp2.

In a last section of the user interface the user interface provides a list of linked interfaces of the respective mechatronic component Comp1, Comp2, which shows the interfaces of the mechatronic component Comp1, Comp2 and the interfaces of other mechatronic components Comp1, Comp2 which are linked to the respective interfaces.

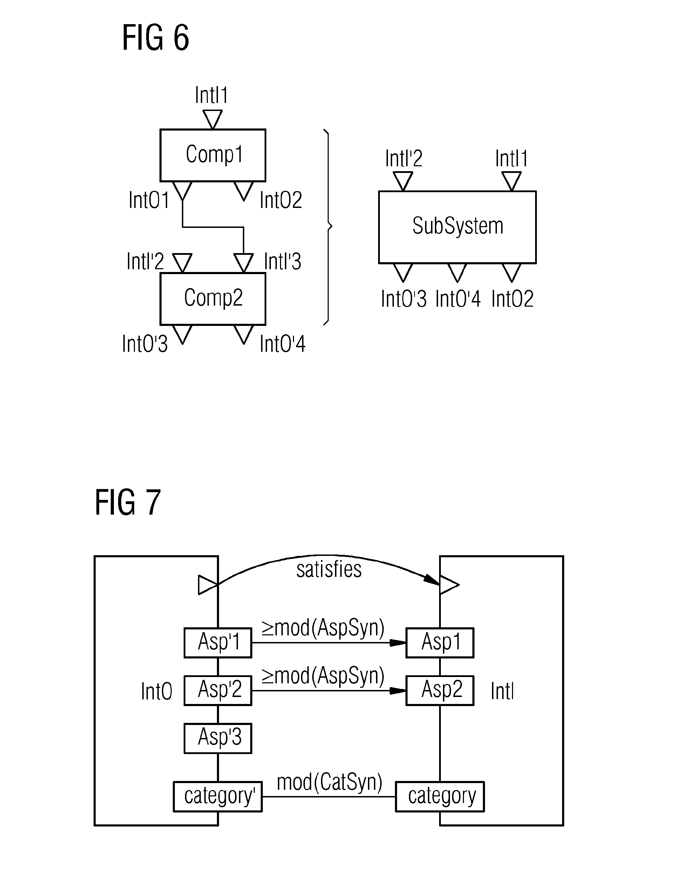

Fig. 6 shows a combination of two mechatronic components Comp1, Comp2 into a subsystem.

In Fig. 7 two mechatronic components Comp1 and Comp2 are displayed, which are linked by Interface IntO1 of mechatronic component Comp1 and IntI'3 of mechatronic component Comp2.

In a generic component description this two components Comp1 and Comp2 could be defined as a sub system SubSystem which would then provide the input interfaces IntI1, IntI'2 of Comp1 and Comp2 and the output interfaces IntO2, IntO'3, IntO'4 of Comp1 and Comp2. Only the interfaces IntO1, Int'I3 which are directly coupled together would be omitted in the description of the sub system SubSystem.

Fig. 7 shows a connection between two interfaces of mechatronic components Comp1, Comp2 according to the present invention.

In Fig. 7 a first Interface IntO is displayed and a second interface IntI is displayed. The first interface IntO into comprises three aspects Asp'1, Asp'2 and Asp'3 and a category. The second interface IntI comprises two aspects Asp1 and Asp2 and a category.

Because in Fig. 7 the second interface IntI comprises a subgroup of the interfaces of the first interface IntO, the first interface IntO satisfies the second interface IntI.

Accordingly, in the user interface of Fig. 5 the first interface IntO would be listed in the suggestion list for suggested interfaces for the first interface IntI.

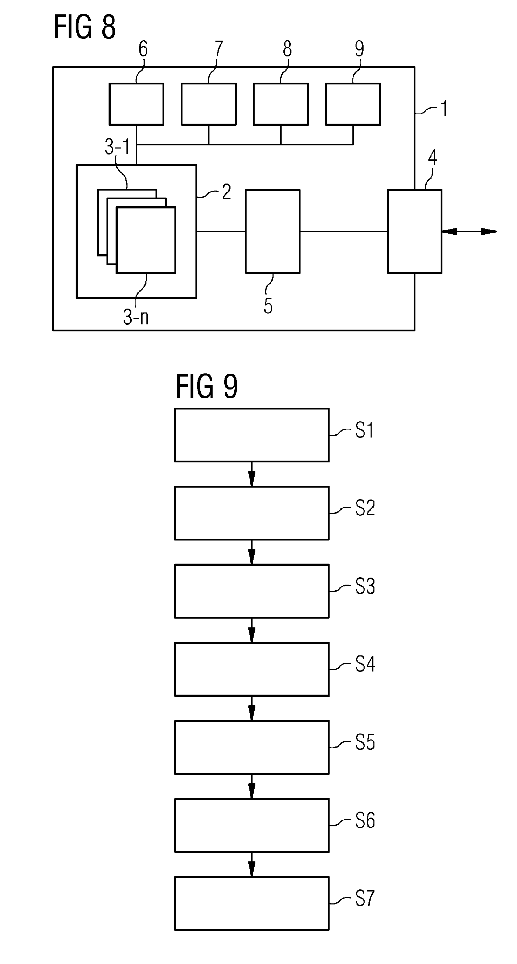

Fig. 8 shows a block diagram of an embodiment of a development system 1 according to the present invention.

The development system 1 of Fig. 8 is based on the development system 1 of Fig. 1 and comprises a first determination unit 6, a second determination unit 7, a first searching unit 8 and a second searching unit 9.

The first determination unit 6 is coupled to the memory 2 and is configured to determine whether a first input and/or output interface IntI1, IntI'2, IntI'3, IntO1, IntO2, IntO'3, IntO'4 satisfies a selected second input and/or output interface IntI1, IntI'2, IntI'3, IntO1, IntO2, IntO'3, IntO'4 and/or whether the first input and/or output interface IntI1, IntI'2, IntI'3, IntO1, IntO2, IntO'3, IntO'4 can be connected to said selected second input and/or output interface IntI1, IntI'2, IntI'3, IntO1, IntO2, IntO'3, IntO'4 and/or whether the first input and/or output interface IntI1, IntI'2, IntI'3, IntO1, IntO2, IntO'3, IntO'4 can be used instead of said selected second input and/or output interface IntI1, IntI'2, IntI'3, IntO1, IntO2, IntO'3, IntO'4.

The second determination unit 7 is coupled to the memory 2 and is configured to determine whether a first mechatronic component Comp1, Comp2 is compatible with a selected second mechatronic component Comp1, Comp2 and/or whether the first mechatronic component Comp1, Comp2 can be connected to said selected second mechatronic component Comp1, Comp2 and/or whether the first mechatronic component Comp1, Comp2 can be used instead of said selected second mechatronic component Comp1, Comp2.

The first searching unit 8 is coupled to the memory 2 and is configured to search all compatible mechatronic components Comp1, Comp2 for a selected mechatronic component Comp1, Comp2.

The second searching unit 9 is coupled to the memory 2 and is configured to search all compatible input and/or output interfaces IntI1, IntI'2, IntI'3, IntO1, IntO2, IntO'3, IntO'4 for a selected input and/or output interface IntI1, IntI'2, IntI'3, IntO1, IntO2, IntO'3, IntO'4.

The determination units 6, 7 and the searching units 8, 9 can be used by the user interface to identify candidate mechatronic components Comp1, Comp2 and candidate input and/or output interfaces IntI1, IntI'2, IntI'3, IntO1, IntO2, IntO'3, IntO'4.

Furthermore, the determination units 6, 7 and the searching units 8, 9 can be used by the development system 1 to conduct consistency checks for linked mechatronic components Comp1, Comp2 or linked interfaces IntI1, IntI'2, IntI'3, IntO1, IntO2, IntO'3, IntO'4.

In the following a detailed description of the notions used for structuring, comparing and combining if mechatronic components will be described:

A component is considered as a triple
*Compᵢ* = *(Name, InInterfaces, Outlnterfaces)*
where ***InInterfaces*** is a set of required interfaces (interfaces Int such ***that Int.InOrOut="Required")*** and ***Outinterfaces*** is a set of provided interfaces (interfaces **Int** such that
***Int.InOrOut= "Provided***").

An Interface in a context of a component ***Comp*** is a tuple
***Comp.Intᵢ = (Name, InOrOut, multiplicity, category, Aspects,** ProprietaryExtension)*
where ***InOrOut*** is a property with possible values ***"Provided"*** or ***"Required"*** (considered in the context of the including component) ; ***multiplicity*** is a property specifying how many connections are allowed to this interface (also considered in the context of the including component) e.g., for a pure SW interface there may be unlimited number of other components connected to this interface, so **would be multiplicity="*"** for such kinds of interfaces; mechanical interfaces may be normally connected to only one plug of the compatible type; ***category*** is a property classifying the interface for more precise future comparison (e.g., if an interface is purely mechanical, then it will be compared only with interfaces containing mechanical properties not to mix them e.g. with SW, where types have different meaning and values); ***Aspects*** is a set of aspects defined below; ***ProprietaryExtension*** is a comment structured corresponding to the specified format.

An aspect of an interface ***Int*** is a named set of specifications
***IntAspectᵢ = (Name, Specifications)***
where ***Specifications*** is a set of interface elements (sometimes considered as Parameters).

A specification of an interface ***Int*** is a tuple
Int.Specᵢ = (Name, multiplicity, Category, Value, Type, Unit, ProprietaryExtension)
*where*
- ***multiplicity*** is a natural number or symbol * standing for unlimited (or no applicable) number. It is considered in the context of the including interface.
- ***Category=(mainName, otherTags)** with **mainName*** being a Standard name of the category (e.g. from the table of registered categories and their synonyms) *and **OtherTags*** being freely defined a set of words (e.g., tool names or language). ***mainName*** is used when filtering interfaces over categories and ***otherTags*** may be used for an extended search procedure over the database or memory 2. Each of these usb- properties maybe empty.
- ***Value=(minValue, maxValue, initialValue)*** with ***minValue*** and ***maxValue*** specifying the minimum and maximum resp. allowed value for this element, ***initialValue*** specifying the initial or default value, if applicable. Each of these usb-properties maybe empty.
- ***Type=(name, subtypes, supertypes) with name*** being a Standard name of the type (e.g. from the table of registered types and their synonyms), ***subtypes** and **Supertypes*** being additional information taken into account when searching for comparable interfaces in the database.
- ***Unit*** is a name of measurement unit (e.g , m, kg, g, degree, <empty> for any numbers)
- ***ProprietaryExtension=(FormatName, TextBody)*** is a comment text ***TextBody*** with a structure corresponding to the format specified in the property ***FormatName***

Because the specifications are considered to be defined by humans, who also will define categories and aspects, tables of synonyms (CatSyn and AspSyn) are useful to be maintained by a kind of administrator role. The table of category synonyms CatSyn comprises a list of pairs (CategoryName1, CategoryName2) meaning CategoryName2 can be used as CategoryName1, i.d. elements with CategoryName2 should be included into the set searched through, whenever elements/interfaces with CategoryName1 are required by a component. If both pairs (CategoryName1,CategoryName2) and (CategoryName1,CategoryName1) are included into the synonym list, both categories can be used equally as real synonyms. A similar table is maintained for aspect synonyms (AspSyn) as well as type definitions (TypSyn). For example (Category1.bool, Category2.Boolean), (Category2.Boolean, Category1.bool) ∈ TypSyn, where Category1 and Category2 may be languages or tools.

The table TypSyn can be provided containing the most used types, which can be extended by users with their own type definitions (automatically or manually).

The functionalities intended to be automated over this generic component definitions proposed by this invention are following:
CompareInterfaces (Comp1.Int1, ***Comp2.Int2),*** used to get an answer in one of the forms: (a) ***Int2->Int1,*** i.e. interface **Int2** satisfies interface **Int1** and can be connected to it *(if **Int1*** is required and **Int2** is provided) or used instead *of **Int1*** (if they are both required or both provided); (b) ***Int1!->Int2,** i.e. **Int1** and **Int2*** are not compatible
***CompareComponents (Comp1, Comp2),*** used to return an answer in one of the forms: (a) ***Comp1<Comp2,** i.e.* **Comp2** is compatible with **Comp1** and can be used instead; (b) *Comp1!=Comp2,* i.e. Comp1 and Comp2 cannot be connected together and cannot be used instead of one another; (c) **Comp1->ₚ Comp2,** i.e. **Comp1** can be (partially) connected to **Comp2** (the missing elements/interfaces can be shown).
SearchAllCompatibleComponents(ComponentName) returns a set of components **Compᵢ,** from the database such that **Comp*ᵢ*->*p* ComponentName.** Such components ***Compᵢ*** will appear in the section "Compatible Components" in the GUI in Fig.5 after selecting ***ComponentName*** as "Candidates for Component:" and clicking "Search for Components" button. SearchAllCompatibleInterfaces(InterfaceName) returns the set of interfaces Intᵢ from the components in the database such that ***Intᵢ-> InterfaceName.*** Such interfaces **Intᵢ** will appear in the section "Compatible Interfaces" in the GUI in Fig.5 after selecting ***ComponentName*** as "Candidates for Component:" and ***InterfaceName*** as "Candidates for Interface:" and clicking "Search for Interfaces" button.

The connection between interfaces within their components is innovative because it takes into account compatibility of aspects, categories, types, and multiplicities of the (enriched definition of) interfaces as well as the equivalence of terms defined in the synonyms tables.

In the following the algorithm of the composition, comparison and candidates search is describer:

The definitions below specify when components and interfaces may be connected together. The connection of components is defined via the connection of their interfaces (provided to required) producing a sub-system of connected components with the interfaces from these components respecting the modified multiplicities of the connected interfaces.

### [Components]

Let Comp1=(id1, {IntI1,...}, {IntO1,...}) and Comp2=(id2, {Intl'1,...},{IntO'1....}) be two components. Comp1 and Comp2 can be connected ***(Comp2->ₚ Comp1)*** producing a subsystem SubSys=(id3, {IntI"1,...}, {IntO"1,... }), if there are interfaces IntIj, ... , IntIn ∈ **Comp1.InInterfaces** and IntO' I, ... IntO' n ∈ *Comp2.**OutInterfaces*** such that IntO' k->IntIm meaning that input interfaces from Comp1 can be connected to Output interfaces of Comp2 (defined below in the next definition).

Then the interfaces of the subsystem SubSys are constructed as follows

Input interfaces of the resulting subsystem IntI"i ∈ *Subsys**.InInterfaces*** are input interfaces from Comp1 or Comp2 not connected to Outputs:
(a) IntI"i ∈ *Comp1**.InInterfaces** Comp2.**InInterfaces*** and NOT(IntOj->IntI"i) for all IntOj ∈ Comp1.OutInterfaces Comp2.OutInterfaces;
*(b) Int"i =* (id"i, Required, multiplicity", category, Aspects), *where IntIj =* (idj, Required, multiplicity, category, Aspects) ∈ Comp1.InInterfaces Comp2.InInterfaces, IntOk = (idk, Provided, multiplicity', category', Aspects') ∈ *Comp1*.OutInterfaces *Comp2*.OutInterfaces *such that IntOk->IntIj and* *≠multiplicity > multiplicity' and multiplicity" = multiplicity - multiplicity'.

Output interfaces of the resulting subsystem IntO"i ∈ SubSys.OutInterfaces are Output interfaces from Comp1 or Comp2 not connected to inputs:
(a) IntO"i ∈ *Comp1.**OutInterfaces** Comp2.**OutInterfaces*** and NOT(IntO"i->IntIj) for all IntIj ∈ *Comp1*.InInterfaces *Comp2*.InInterfaces;
*(b) IntO"i =* (id"i, Provided, multiplicity", category, Aspects), *where IntOj =* (idj, Provided, multiplicity, category, Aspects) ∈ Comp1.OutInterfaces Comp2.OutInterfaces *and IntIk* = (idk, Required, multiplicity', category', Aspects') ∈ Comp1.InInterfaces Comp2.InInterfaces, such *that IntOj-> IntIk,* multiplicity > multiplicity' or multiplicity =*, and multiplicity" = multiplicity - multiplicity' *(in case* multiplicity ≠*) or multiplicity" =* *(in case* multiplicity = *).

### [Interfaces]

*Let IntI* = (id, Required, mult, category, Aspects) with Aspects = {Aspect1, ..., Aspectj} *be a definition of a required interface and IntO* = (id', Provided, mult', Category' , Aspects') *with* Aspects' = *{AspectO1, ..., AspectOk}* be a definition of a provided interface from the same or a different component.

Then IntO->IntI means that the required interface ***Intl*** can be satisfied by the provided interface *IntO* which is defined as following (all the statements must be true):
- If category ≠ *<empty> and* category' ≠ *<empty> then* Category ≈_{mod(catSyn)} category' ;
   •..................... {AspectI1, ..., AspectIj} C_{ASpsyn} {AspectO1, ..., AspectOk}, i.e all aspects from **Intl** appear (modulo the table of synonyms AspSyn) in the aspects of the provided interface *IntO.*
- For each element specName ∈ IntI.AspectIi (from an AspectIi of the required interface IntI) there is an element specName' ∈ IntO.AspectOj such that
   ○ AspectIi ≈_{mod(AspSyn)} AspectOj &
   o If speCName.multiplicity ≠ * and
      specName'.multiplicity ≠ * then
      specName'.multiplicity ≤ specName.multiplicity &
   o specName'.Category.mainName
      ∈ _{mod(Catsyn)} {specName.Category.mainName}
      specName.Category.otherTags &
   o If specName.Value.minValue ≠ <empty> then
      specName'.Value.minValue ≥
      specName'.Value.minValue; if
      specName.Value.maxValue ≥ <empty> then
      specName'.Value.maxValue ≤ specName'.Value.maxValue &
   o specName'.Type.name ≈_{mod(TypSyn)} specName.Type.name or
      specName'.Type.name ∈_{mod(Typsyn)}
      specName.Type.subtypes &
   o specName'.Unit.name = specName.Unit.name or
      specName.Unit.name = <empty>.

All interface pairs (IntI, IntO) found in the database of generic component descriptions such that IntO->IntI as defined above are kept in a list ***CandidateInterfaces*** in one emobidment. These pairs can be shown in the GUI in Fig. 5, where a user can select some or all of them and specify the selected pairs as acknowledged links (moving them to another pairs *list **RelatedInterfaces)*** or as rejected links (moving them to another pairs list ***RejectedConnections**).*

Fig. 9 shows a flow diagram of an embodiment of a method according to the present invention.

The flow diagram of Fig. 9 is based on the flow diagram of Fig. 3 and comprises the following further steps:
Determining (S4) whether a first input and/or output interface IntI1, IntI'2, IntI'3, IntO1, IntO2,IntO'3, IntO'4 satisfies a selected second input and/or output interface IntI1, IntI'2, IntI'3, IntO1, IntO2,IntO'3, IntO'4 and/or whether the first input and/or output interface IntI1, IntI'2, IntI'3, IntO1, IntO2,IntO'3, IntO'4 can be connected to said selected second input and/or output interface IntI1, IntI'2, IntI'3, IntO1, IntO2,IntO'3, IntO'4 and/or whether the first input and/or output interface IntI1, IntI'2, IntI'3, IntO1, IntO2,IntO'3, IntO'4 can be used instead of said selected second input and/or output interface IntI1, IntI'2, IntI'3, IntO1, IntO2,IntO'3, IntO'4.
Determining (S5) whether a first mechatronic component Comp1, Comp2 is compatible with a second mechatronic component Comp1, Comp2 and/or whether the first mechatronic component Comp1, Comp2 can be connected to the second mechatronic component Comp1 , Comp2 and/or whether the first mechatronic component Comp1, Comp2 can be used instead of the second mechatronic component by comparing the input and/or output interfaces IntI1, IntI'2, IntI'3, IntO1, IntO2,IntO'3, IntO'4 of said first and second mechatronic components Comp1, Comp2.
Searching (S6) all compatible mechatronic components Comp1, Comp2 for a selected mechatronic component Comp1, Comp2. Searching (S7) all compatible input and/or output interfaces IntI1, IntI'2, IntI'3, IntO1, IntO2,IntO'3, IntO'4 for a selected input and/or output interface IntI1, IntI'2, IntI'3, IntO1, IntO2,IntO'3, IntO'4.

Although specific embodiments have been illustrated and described herein, it will be appreciated by those of ordinary skill in the art that a variety of alternate and/or equivalent implementations exist. It should be appreciated that the exemplary embodiment or exemplary embodiments are only examples, and are not intended to limit the scope, applicability, or configuration in any way. Rather, the foregoing summary and detailed description will provide those skilled in the art with a convenient road map for implementing at least one exemplary embodiment, it being understood that various changes may be made in the function and arrangement of elements described in an exemplary embodiment without departing from the scope as set forth in the appended claims and their legal equivalents. Generally, this application is intended to cover any adaptations or variations of the specific embodiments discussed herein.

In the foregoing detailed description, various features are grouped together in one or more examples or examples for the purpose of streamlining the disclosure. It is understood that the above description is intended to be illustrative, and not restrictive. It is intended to cover all alternatives, modifications and equivalents as may be included within the scope of the invention. Many other examples will be apparent to one skilled in the art upon reviewing the above specification.

Specific nomenclature used in the foregoing specification is used to provide a thorough understanding of the invention. However, it will be apparent to one skilled in the art in light of the specification provided herein that the specific details are not required in order to practice the invention. Thus, the foregoing descriptions of specific embodiments of the present invention are presented for purposes of illustration and description. They are not intended to be exhaustive or to limit the invention to the precise forms disclosed; obviously many modifications and variations are possible in view of the above teachings. The embodiments were chosen and described in order to best explain the principles of the invention and its practical applications, to thereby enable others skilled in the art to best utilize the invention and various embodiments with various modifications as are suited to the particular use contemplated. Throughout the specification, the terms "including" and "in which" are used as the plain-English equivalents of the respective terms "comprising" and "wherein," respectively. Moreover, the terms "first," "second," and "third," etc., are used merely as labels, and are not intended to impose numerical requirements on or to establish a certain ranking of importance of their objects.

## Claims

1. A development system (1) for developing mechatronic systems (20), comprising:
a memory (2) configured to store generic component descriptions (3-1 - 3-n) of mechatronic components (Comp1, Comp2) of the mechatronic systems (20);
at least one system interface (4) coupled to said memory and configured to exchange the generic component descriptions (3-1 - 3-n) with development tools of different development domains provided for developing the mechatronic systems (20);
at least one adaptor (5) coupled to said at least one system interface (4);
wherein the stored generic component descriptions (3-1 - 3-n) comprise generic descriptions of the input and/or output interfaces (IntIl, IntI'2, IntI'3, IntO1, IntO2,IntO'3, IntO'4) of the mechatronic components (Comp1, Comp2) of the mechatronic system (20); and
wherein said at least one adaptor (5) is configured to translate the stored generic component descriptions (3-1 - 3-n) into tool specific component descriptions of said development tools and/or translate the tool specific component descriptions of said development tools into generic component descriptions (3-1 - 3-n).

2. The development system according to claim 1,
wherein the generic component descriptions (3-1 - 3-n) comprise at least a name of the corresponding mechatronic component (Comp1, Comp2) and/or a list of input interfaces (IntIl, IntI'2, IntI'3) of the corresponding mechatronic components (Comp1, Comp2) and/or a list of output interfaces (IntO1, IntO2, IntO'3, IntO'4) of the corresponding mechatronic components (Comp1, Comp2).

3. The development system according to claim 2,
wherein the description of the input interfaces (IntIl, IntI'2, IntI'3) and/or the output interfaces (IntO1, IntO2, IntO'3, IntO'4) of the corresponding mechatronic components (Comp1, Comp2) comprises at least a name and/or one of the types input or output and/or a multiplicity and/or a category and/or at least one aspect and/or at least one proprietary extension.

4. The development system according to claim 3,
wherein every aspect in a description of one of the input and/or output interfaces (IntIl, IntI'2, IntI'3, IntO1, IntO2, IntO'3, IntO'4) comprises a specification about the respective input and/or output interface (IntIl, IntI'2, IntI'3, IntO1, IntO2, IntO'3, IntO'4) for one specific development domain; and/or
wherein every proprietary extension of one of the input and/or output interfaces (IntIl, IntI'2, IntI'3, IntO1, IntO2, IntO'3, IntO'4) comprises information data which is provided in a proprietary format of at least one of the development tools.

5. The development system according to claim 1,
wherein the generic component descriptions (3-1 - 3-n) are provided in a human readable format, especially in an XML format.

6. The development system according to claim 1,
wherein the at least one adaptor is configured to translate the generic component descriptions (3-1 - 3-n) into a component description according to a standardized description format.

7. The development system according to claim 1, comprising a first determination unit (6) coupled to the memory and configured to determine whether a first input and/or output interface (IntIl, IntI'2, IntI'3, IntO1, IntO2,IntO'3, IntO'4) satisfies a selected second input and/or output interface (IntIl, IntI'2, IntI'3, IntO1, IntO2,IntO'3, IntO'4) and/or whether the first input and/or output interface (IntIl, IntI'2, IntI'3, IntO1, IntO2,IntO'3, IntO'4) can be connected to said selected second input and/or output interface (IntIl, IntI'2, IntI'3, IntO1, IntO2, IntO'3, IntO'4) and/or whether the first input and/or output interface (IntIl, IntI'2, IntI'3, IntO1, IntO2, IntO'3, IntO'4) can be used instead of said selected second input and/or output interface (IntIl, IntI'2, IntI'3, IntO1, IntO2, IntO'3, IntO'4).

8. The development system according to claim 1, comprising a second determination unit (7) coupled to the memory and configured to determine whether a first mechatronic component (Comp1, Comp2) is compatible with a selected second mechatronic component (Comp1, Comp2) and/or whether the first mechatronic component (Comp1, Comp2) can be connected to said selected second mechatronic component (Comp1, Comp2) and/or whether the first mechatronic component (Comp1, Comp2) can be used instead of said selected second mechatronic component (Comp1, Comp2).

9. The development system according to claim 1, comprising a first searching unit (8) coupled to the memory and configured to search all compatible mechatronic components (Comp1, Comp2) for a selected mechatronic component (Comp1, Comp2).

10. The development system according to claim 1, comprising a second searching unit (9) coupled to the memory and configured to search all compatible input and/or output interfaces (IntIl, IntI'2, IntI'3, IntO1, IntO2,IntO'3, IntO'4) for a selected input and/or output interface (IntIl, IntI'2, IntI'3, IntO1, IntO2, IntO'3, IntO'4).

11. A non-transitory data carrier (10), especially for use in a development system (1) according to any one of claims 1 to 11, comprising:
a data structure, the data structure comprising:
generic component descriptions (3-1 - 3-n) of mechatronic components (Comp1, Comp2) of the mechatronic systems (20),
wherein the generic component descriptions (3-1 - 3-n) comprise at least a name (10) of the corresponding mechatronic components (Comp1, Comp2) and/or a list (11) of input interfaces (IntIl, IntI'2, IntI'3) of the corresponding mechatronic components (Comp1, Comp2) and/or a list (12) of output interfaces (IntO1, IntO2, IntO'3, IntO'4) of the corresponding mechatronic components (Comp1, Comp2); and
wherein the list of the input interfaces (IntIl, IntI'2, IntI'3) and/or the list of the output interfaces (IntO1, IntO2, IntO'3, IntO'4) of the corresponding mechatronic components (Comp1, Comp2) comprises at least a name and/or one of the types input or output and/or a multiplicity and/or a category and/or at least one aspect and/or at least one proprietary extension; and/or
wherein every aspect in a description of one of the input and/or output interfaces (IntIl, IntI'2, IntI'3, IntO1, IntO2,IntO'3, IntO'4) comprises a specification about the respective input and/or output interface (IntIl, IntI'2, IntI'3, IntO1, IntO2, IntO'3, IntO'4) for one specific development domain; and/or
wherein every proprietary extension of one of the input and/or output interfaces (IntIl, IntI'2, IntI'3, IntO1, IntO2, IntO'3, IntO'4) comprises an information which is provided in a proprietary format of at least one of the development tools.

12. The non-transitory data carrier according to claim 11, wherein said generic component descriptions (3-1 - 3-n) are provided in a human readable format, especially in an XML format.

13. The non-transitory data carrier according to claim 11, comprising a computer program, which when executed causes a processor to:
translate generic component descriptions (3-1 - 3-n) into tool specific component descriptions of development tools provided for developing mechatronic systems (20), and
send the translated generic component descriptions (3-1 - 3-n) to development tools of different development domains; and/or
receive tool specific component descriptions from said development tools, and translate the tool specific component descriptions of said development tools into generic component descriptions (3-1 - 3-n); and/or
determine whether a first input and/or output interface (IntIl, IntI'2, IntI'3, IntO1, IntO2, IntO'3, IntO'4) satisfies a selected second input and/or output interface (IntIl, IntI'2, IntI'3, IntO1, IntO2, IntO'3, IntO'4) and/or whether the first input and/or output interface (IntIl, IntI'2, IntI'3, IntO1, IntO2, IntO'3, IntO'4) can be connected to said selected second input and/or output interface (IntIl, IntI'2, IntI'3, IntO1, IntO2, IntO'3, IntO'4) and/or whether the first input and/or output interface (IntIl, IntI'2, IntI'3, IntO1, IntO2, IntO'3, IntO'4) can be used instead of said selected second input and/or output interface (IntIl, IntI'2, IntI'3, IntO1, IntO2, IntO'3, IntO'4); and/or
determine whether a first mechatronic component (Comp1, Comp2) is compatible with a second mechatronic component (Comp1, Comp2) and/or whether the first mechatronic component (Comp1, Comp2) can be connected to the second mechatronic component (Comp1, Comp2) and/or whether the first mechatronic component (Comp1, Comp2) can be used instead of the second mechatronic component by comparing the input and/or output interfaces (IntIl, IntI'2, IntI'3, IntO1, IntO2, IntO'3, IntO'4) of said first and second mechatronic components (Comp1, Comp2); and/or search all compatible mechatronic components (Comp1, Comp2) for a selected mechatronic component (Comp1, Comp2); and/or
search all compatible input and/or output interfaces (IntIl, IntI'2, IntI'3, IntO1, IntO2, IntO'3, IntO'4) for a selected input and/or output interface (IntIl, IntI'2, IntI'3, IntO1, IntO2, IntO'3, IntO'4).

14. A method for developing mechatronic systems (20), comprising the steps:
storing (S1) generic component descriptions (3-1 - 3-n) of mechatronic components (Comp1, Comp2) of the mechatronic systems (20), wherein the stored generic component descriptions (3-1 - 3-n) comprise generic descriptions of the input and/or output interfaces (IntIl, IntI'2, IntI'3, IntO1, IntO2, IntO'3, IntO'4) of the mechatronic components (Comp1, Comp2) of the mechatronic system (20);
translating (S2) the stored generic component descriptions (3-1 - 3-n) into tool specific component descriptions of development tools provided for developing the mechatronic systems (20), and sending the translated generic component descriptions (3-1 - 3-n) to development tools of different development domains; and/or
receiving (S3) tool specific component descriptions from said development tools, and translating the tool specific component descriptions of said development tools into generic component descriptions (3-1 - 3-n).

15. The method according to claim 14,
wherein the generic component descriptions (3-1 - 3-n) comprise at least a name of the corresponding mechatronic components (Comp1, Comp2) and/or a list of input interfaces (IntIl, IntI'2, IntI'3) of the corresponding mechatronic components (Comp1, Comp2) and/or a list of output interfaces (IntO1, IntO2, IntO'3, IntO'4) of the corresponding mechatronic components (Comp1, Comp2); and
wherein the description of the input interfaces (IntIl, IntI'2, IntI'3) and/or the output interfaces (IntO1, IntO2, IntO'3, IntO'4) of the corresponding mechatronic components (Comp1, Comp2) comprises at least a name and/or one of the types input or output and/or a multiplicity and/or a category and/or at least one aspect and/or at least one proprietary extension; and
wherein every aspect in a description of one of the input and/or output interfaces (IntIl, IntI'2, IntI'3, IntO1, IntO2, IntO'3, IntO'4) comprises a specification about the respective input and/or output interface (IntIl, IntI'2, IntI'3, IntO1, IntO2, IntO'3, IntO'4) for one specific development domain; and
wherein every proprietary extension of one of the input and/or output interfaces (IntIl, IntI'2, IntI'3, IntO1, IntO2, IntO'3, IntO'4) comprises information data which is provided in a proprietary format of at least one of the development tools.

16. The method according to claim 14,
wherein when translating the generic component descriptions (3-1 - 3-n) into a component description the generic component descriptions (3-1 - 3-n) are translated into a standardized description format.

17. The method according to claim 14, comprising the step:
determining (S4) whether a first input and/or output interface (IntIl, IntI'2, IntI'3, IntO1, IntO2, IntO'3, IntO'4) satisfies a selected second input and/or output interface (IntIl, IntI'2, IntI'3, IntO1, IntO2, IntO'3, IntO'4) and/or whether the first input and/or output interface (IntIl, IntI'2, IntI'3, IntO1, IntO2, IntO'3, IntO'4) can be connected to said selected second input and/or output interface (IntIl, IntI'2, IntI'3, IntO1, IntO2, IntO'3, IntO'4) and/or whether the first input and/or output interface (IntIl, IntI'2, IntI'3, IntO1, IntO2, IntO'3, IntO'4) can be used instead of said selected second input and/or output interface (IntIl, IntI'2, IntI'3, IntO1, IntO2, IntO'3, IntO'4).

18. The method according to claim 14, comprising the step:
determining (S5) whether a first mechatronic component (Comp1, Comp2) is compatible with a second mechatronic component (Comp1, Comp2) and/or whether the first mechatronic component (Comp1, Comp2) can be connected to the second mechatronic component (Comp1, Comp2) and/or whether the first mechatronic component (Comp1, Comp2) can be used instead of the second mechatronic component by comparing the input and/or output interfaces (IntIl, IntI'2, IntI'3, IntO1, IntO2, IntO'3, IntO'4) of said first and second mechatronic components (Comp1, Comp2).

19. The method according to claim 14, comprising the step searching (S6) all compatible mechatronic components (Comp1, Comp2) for a selected mechatronic component (Comp1, Comp2).

20. The method according to claim 14, comprising the step searching (S7) all compatible input and/or output interfaces (IntI1, IntI'2, IntI'3, IntO1, IntO2,IntO'3, IntO'4) for a selected input and/or output interface (IntIl, IntI'2, IntI'3, IntO1, IntO2, IntO'3, IntO'4).
